# FASCICULE DE BREVET EUROPEEN

(11) **EP 2 673 473 B1**
(45) Date de publication et mention de la délivrance du brevet: **26.10.2016**
(21) Numéro de dépôt: 12707871.5
(22) Date de dépôt: 06.02.2012
(51) Int. Cl.: F01D 5/14

(54) **ENSEMBLE PALE-PLATEFORME POUR ECOULEMENT SUPERSONIQUE.**
SCHAUFELPLATTFORMANORDNUNG FÜR ÜBERSCHALLSTRÖMUNGEN
BLADE-PLATFORM ASSEMBLY FOR SUPERSONIC FLOW

(30) Priorité: 10.02.2011 FR 1151070
(43) Date de publication de la demande: 18.12.2013
(73) Titulaire: SNECMA, 75015 Paris (FR)
(72) Inventeur: CELLIER, Damien, F-75012 Paris (FR); PERROT, Vincent, Paul, Gabriel, F-94700 Maisons-alfort (FR); RIOS, Jean-François, F-77176 Nandy (FR)
(74) Mandataire: Duflos, Bertrand Guillaume
(86) Numéro de dépôt international: PCT/FR2012/050254
(87) Numéro de publication internationale: WO 2012/107677

(56) Documents cités:
- EP-A1- 1 270 872
- DE-A1-102008 021 053
- FR-A1- 2 928 174
- US-A1- 2003 170 124

## Description

L'invention concerne un ensemble comportant une pale pour roue à aubes de turbomachine et une plateforme sur laquelle la pale doit être montée, l'ensemble ainsi formé étant agencé de telle sorte qu'une pluralité de pales fixées sur la plateforme ou sur une pluralité de plateformes assemblées ensemble, puissent former une roue à aubes. Par plateforme, on désigne ici une pièce qui délimite du côté radialement intérieur une veine inter-aubes formée entre deux pales adjacentes d'une roue à aubes. Par 'surface de plateforme', on désigne la surface de la plateforme qui est en regard de la veine inter-aubes. La surface de plateforme peut aussi désigner collectivement l'ensemble des surfaces de plateforme d'une roue à aubes.

De manière connue en soi, les pales d'une roue à aubes peuvent être formées intégralement avec le disque de rotor pour constituer une roue à aubes. La pièce ainsi formée, réunissant les pales et leurs plateformes, est dénommée 'Disque Aubagé Monobloc' ou DAM. Dans un autre mode de réalisation, les pales sont formées de manière indépendante du disque de rotor (c'est-à-dire qu'il s'agit de pièces distinctes). Dans ce cas, les pales sont formées avec un pied pour leur fixation sur le disque de rotor, et constituent ainsi des aubes. L'assemblage des aubes sur le disque de rotor permet alors de constituer une roue à aubes.

L'invention vise un agencement avantageux de la pale en relation avec la surface de plateforme ; un tel agencement peut être mis en oeuvre dans les différents modes de réalisation présentés précédemment, indépendamment du fait que la plateforme et la pale constituent ou non des pièces distinctes.

L'invention vise plus particulièrement la réalisation d'ensembles tels que présentés précédemment pour former des roues à aubes de compresseurs (haute pression ou basse pression), et notamment de compresseurs multi-étages, implantés dans des turbomachines ou dans des turbomoteurs d'hélicoptères. L'invention peut en outre également être mise en oeuvre pour réaliser des aubes ou roues à aubes de turbines de turbomachines (haute pression ou basse pression).

Le rendement aérodynamique d'un étage de compresseur (égal au ratio entre le travail idéal (le travail idéal étant le travail associé à une transformation isentropique) et le travail réellement fourni au fluide pour obtenir une augmentation de pression donnée entre l'amont et l'aval de l'étage de compresseur) dans une turbomachine dépend non seulement de la forme des pales, mais également de la forme des plateformes. Pour améliorer ce rendement, il est connu de modifier la surface de plateforme dans une ou plusieurs roues à aubes pour augmenter ou réduire localement la section de passage du flux de fluide à travers la ou les roues à aubes. Dans ce but, de manière connue on modifie la plateforme en aménageant dans la surface de celle-ci au niveau des pales, une dépression circonférentielle, et/ou une plage bombée circonférentielle. (Le terme dépression ou plage bombée 'circonférentielle' désigne ici une dépression ou plage bombée ayant sensiblement une forme de révolution, hormis naturellement au voisinage immédiat des pales).

Une roues à aubes dans laquelle les surfaces de plateforme présentent une plage bombée circonférentielle est ainsi présentée par le document EP 1270872.

Une telle modification, appelée 'contouring', permet d'améliorer le rendement aérodynamique de la roue à aube et plus globalement de l'étage de compresseur. Les termes 'dépression' et 'plage bombée' doivent se comprendre en référence à une surface théorique délimitant radialement intérieurement la veine et évoluant linéairement de l'amont à l'aval de la roue à aubes.

Cependant, malgré l'augmentation de rendement ainsi obtenue pour la roue à aube, une telle modification entraîne généralement également certains effets indésirables sur le flux de fluide. En effet :
- elle peut induire des gradients de pression élevés en sortie de la roue à aubes ; de tels gradients étant préjudiciables au fonctionnement de la roue à aubes, notamment au fonctionnement global de la turbomachine, en particulier dans le cas de compresseurs multi-étages ;
- elle peut induire des disparités dans les répartitions de vitesse autour des pales, et notamment au voisinage du pied de celles-ci ; et
- elle peut enfin induire une modification du taux de compression de la roue (le taux de compression étant égal au rapport entre les pressions en amont et en aval de la roue à aubes).

Lorsque de tels effets secondaires indésirables sont constatés, on y remédie généralement en modifiant la géométrie des roues à aubes situées dans la veine de fluide en aval de la roue à aubes considérée. Cependant, ces modifications peuvent ne pas permettre de conserver le gain en rendement permis par la modification de la surface de plateforme de la roue à aubes considérée ; en outre, il n'est pas toujours possible de réaliser de telles modifications.

L'objectif de l'invention est de remédier à de tels inconvénients en proposant un ensemble comportant une pale pour roue à aubes de turbomachine et une plateforme sur laquelle la pale est apte à être montée ;
une pluralité desdites pales étant aptes à être fixées sur ladite plateforme ou sur une pluralité desdites plateformes assemblées ensemble, de manière à former une roue à aubes présentant un axe de roue et définissant suivant celui-ci des directions amont et aval, roue dans laquelle les pales sont disposées radialement ;
dans ladite roue, la plateforme ou les plateformes assemblées présentant entre les pales une surface dite surface de plateforme, délimitant radialement du côté intérieur des veines de passage de gaz formées entre les pales ;
ladite surface de plateforme présentant une dépression circonférentielle, s'étendant axialement sensiblement entre un bord d'attaque et un bord de fuite de la pale, une section la plus creuse de ladite dépression se situant axialement dans la moitié amont de la pale,
ensemble qui confère un bon rendement aérodynamique à la roue à aubes, assure des gradients de pression en aval de la roue à aubes similaires à ceux qui seraient constatés en l'absence de la dépression circonférentielle de la surface de plateforme, et permette d'obtenir des répartitions de vitesse du fluide relativement homogènes, notamment au voisinage du pied d'aube, et cela, pour des aubes appelées à fonctionner dans un écoulement supersonique.

Afin de présenter la solution apportée par l'invention, on définit les éléments suivants :
Le voisinage de la plateforme vise la partie de la pale située à faible distance (par exemple, à moins de 40% de la hauteur de la pale) au-dessus des congés de raccordement entre la pale et la plateforme. L'angle squelette est l'angle que forme la fibre neutre de la pale par rapport à l'axe de la roue à aubes, dans un plan perpendiculaire à la direction longitudinale de la pale, le signe de l'angle squelette étant choisi de telle sorte que l'angle squelette amont (angle squelette au bord d'attaque de la pale) soit positif.
La courbe de squelette est la courbe représentant les variations d'un angle squelette de la pale dans un plan de section parallèle à la surface de plateforme, en fonction de la position suivant l'axe de la roue,
La courbe de squelette linéarisé est la courbe représentative des variations d'un angle en fonction de la position suivant l'axe de la roue, qui relie en ligne droite les points représentant l'angle squelette respectivement à 10% et à 90% de l'étendue axiale de la pale à partir du bord d'attaque. L'angle squelette linéarisé, représenté par la courbe de squelette linéarisé, est donc égal à l'angle squelette à 10% et à 90% de l'étendue axiale de la pale à partir du bord d'attaque (les extrémités amont et aval de la pale, qui peuvent faire l'objet d'aménagements spécifiques, ne sont pas prises en compte).

L'objectif indiqué précédemment est atteint selon l'invention grâce au fait que, dans un ensemble tel qu'indiqué précédemment, dans un voisinage de la plateforme, la courbe de squelette présente une partie réhaussée se trouvant au-dessus de la courbe de squelette linéarisé.

Ainsi, l'invention consiste à modifier localement la forme de la pale de manière à rehausser la courbe de squelette (ce qui revient à 'fermer' l'angle squelette, dans le sens où l'angle squelette dans la section considérée augmente en valeur absolue par rapport à la courbe de squelette linéarisé), afin d'adapter la pale à la modification du flux induite par la dépression circonférentielle aménagée dans la plateforme. On peut considérer qu'il y a un tel réhaussement de la courbe squelette dès lors qu'au moins un point de cette courbe se trouve à plus de 3° au-dessus de la courbe squelette linéarisé. L'aménagement de la pale au voisinage de la plateforme permet un fonctionnement optimal de la roue à aubes, prenant en compte la modification de la surface de plateforme constituée par la dépression circonférentielle.

L'étendue axiale de la pale (notée E dans ce qui suit) désigne la distance, mesurée au pied de pale et suivant l'axe de la roue à aubes, entre le bord d'attaque et le bord de fuite de la pale.

Dans un ensemble selon l'invention, du fait de la partie rehaussée que présente la courbe d'évolution de l'angle squelette ou courbe squelette, sur une partie radialement inférieure de la pale, le flux de gaz ou d'air est dévié de manière à :
- limiter l'accélération induite par l'application du 'contouring' dans le repère relatif à l'aube, au niveau de la dépression circonférentielle. La limitation de l'augmentation de vitesse du flux de fluide permet ainsi de réduire les pertes par onde de choc (grâce à la fermeture de l'angle squelette, notamment dans la plage s'étendant de 0 à 40% de l'étendue axiale de la pale) ; et
- limiter l'augmentation de débit au voisinage de la plateforme induite par la dépression circonférentielle, de manière à redonner au gradient de débit à sa valeur initiale, c'est-à-dire la valeur qu'il aurait s'il n'y avait pas la dépression circonférentielle ou plus généralement le contouring.

Aussi en écoulement supersonique, une roue à aubes intégrant des ensembles selon l'invention présente un bon rendement aérodynamique, avec des gradients de pression en aval de la roue à aubes similaires à ceux qui seraient constatés en l'absence de la dépression circonférentielle, et des répartitions de vitesse du fluide au voisinage du pied d'aube relativement homogènes.

L'ensemble selon l'invention peut faire l'objet des perfectionnements suivants :
- Un plan dans lequel un écart entre la courbe de squelette et la courbe de squelette linéarisé est maximum peut être sensiblement confondu avec le plan de ladite section la plus creuse.
- Un plan dans lequel un écart entre la courbe de squelette et la courbe de squelette linéarisé est maximum peut être situé axialement entre la position 0,5 x N% de la section la plus creuse et 1,5 x N%, la valeur N étant un pourcentage exprimé par rapport à l'étendue axiale de la pale à partir de son bord d'attaque.
- La section la plus creuse peut être située axialement entre 15 et 40% de l'étendue axiale de la pale, à partir de son bord d'attaque.
- La courbe squelette et la courbe de squelette linéarisé peuvent se croiser en un point situé entre 50% et 75% de l'étendue axiale de la pale à partir de son bord d'attaque.
- La courbe squelette peut présenter une partie abaissée se trouvant sous la courbe d'angle squelette linéarisé et située axialement en aval de ladite partie rehaussée. Du fait de la partie abaissée, sur une partie radialement inférieure de la pale, la déviation imposée au fluide est limitée ce qui permet d'annuler l'augmentation de l'écart flux-profil au niveau du bord de fuite de la pale, induite par l'aménagement de la dépression circonférentielle (L'écart flux profil étant l'écart entre la direction du flux au voisinage du bord de fuite et l'angle squelette aval). L'ouverture de veine induite par la dépression circonférentielle entraîne un désamorçage de la pale, ce qui permet d'appliquer cet aménagement. Le recalage de l'écart flux-profil à sa valeur d'origine permet de conserver l'angle de sortie du fluide et donc le gradient de taux de compression, tout en améliorant les performances aérodynamiques de la pale.

Un deuxième objectif de l'invention est de proposer une aube pour turbomachine comprenant une plateforme formée intégralement avec au moins une pale, qui confère un bon rendement aérodynamique à une roue à aubes formée à l'aide de telles aubes, assure des gradients de pression en aval de la roue à aubes similaires à ceux qui seraient constatés en l'absence de la dépression circonférentielle de la surface de plateforme, et permette d'obtenir des répartitions de vitesses relativement homogènes, notamment au voisinage du pied d'aube.

Cet objectif est atteint grâce au fait que l'aube pour turbomachine comporte un ensemble tel que défini précédemment. Les plateformes de ces aubes sont en général agencées de telle sorte qu'elles définissent entièrement la surface inter-aubes délimitant radialement du côté intérieur des veines de passage de gaz formées entre les pales.

Un troisième objectif de l'invention est de proposer une roue à aubes pour turbomachine, qui présente un bon rendement aérodynamique, des gradients de pression en aval de la roue à aubes similaires à ceux qui seraient constatés en l'absence de la dépression circonférentielle de la surface de plateforme, et des répartitions de vitesses relativement homogènes, notamment au voisinage du pied d'aube.

Cet objectif est atteint grâce au fait que la roue à aubes est formée avec des aubes telles que définies précédemment, ou encore est formée avec au moins un ensemble tel que défini précédemment. Un disque à aubes monobloc constitue un exemple d'une telle roue à aubes.

Enfin, l'invention peut avantageusement être intégrée dans une turbomachine comprenant au moins une roue à aubes telle que définie précédemment.

L'invention sera bien comprise et ses avantages apparaîtront mieux à la lecture de la description détaillée qui suit, de modes de réalisation représentés à titre d'exemples non limitatifs. La description se réfère aux dessins annexés, sur lesquels :
la figure 1 est une vue schématique en perspective d'un étage de compresseur d'une turbomachine selon l'invention ;
la figure 2 est une vue schématique en perspective de trois ensembles selon l'invention, faisant partie de la roue présentée en figure 1 ;
chacune des figures 3A et 3B est une figure représentant un ensemble comprenant une plateforme associée à une pale, et comprenant :
   (a) une vue schématique dudit ensemble suivant la direction circonférentielle ;
   (b) un diagramme montrant la courbe de squelette de la pale dudit ensemble ;
la figure 3A présentant un ensemble connu, et la figure 3B un ensemble selon l'invention dans un premier mode de réalisation ;
la figure 4 est un diagramme montrant deux variantes pour la courbe de squelette d'une pale d'un ensemble selon l'invention, correspondant respectivement au premier mode de réalisation et à un deuxième mode de réalisation ; et
la figure 5 est une section d'une pale d'un ensemble selon l'invention.

Dans les différentes figures, les éléments identiques ou similaires comportent la même référence.

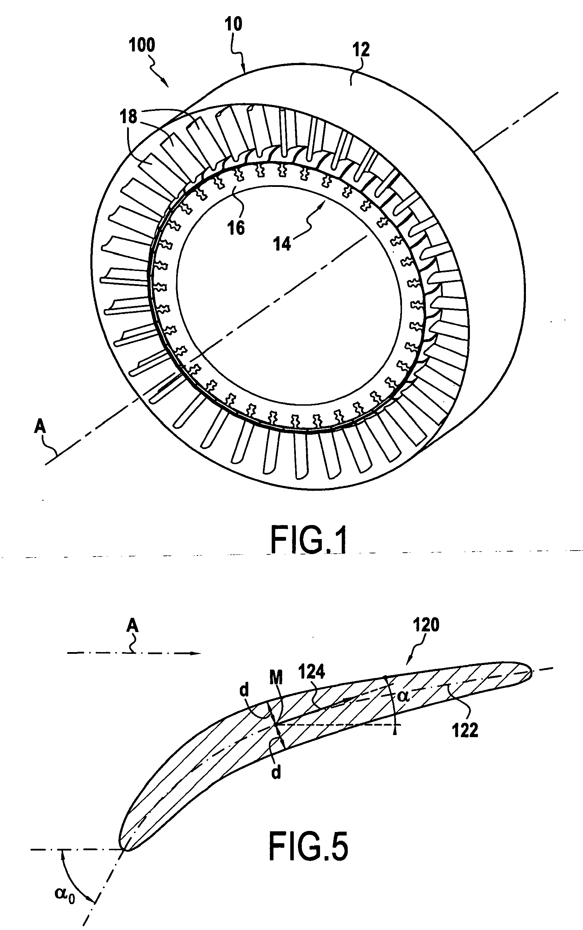

La figure 1 représente une partie d'un compresseur à flux axial 10 d'une turbomachine 100. Ce compresseur 10 comprend un carter 12, dans lequel est montée une roue à aubes 14. La roue à aubes 14 comprend elle-même un disque rotor 16, sur lequel sont fixées de manière connue en soi des aubes radiales 18, de manière axisymétrique. La roue à aubes est agencée de manière à pouvoir tourner suivant un axe de rotation A à l'intérieur du carter 12.

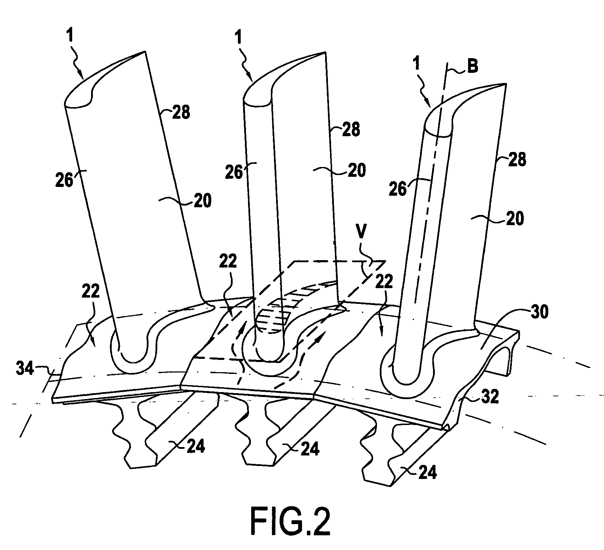

L'agencement des aubes 18 de la roue à aubes 14 est présenté plus en détail par la figure 2, qui est une vue partielle de la roue 14.

Dans la roue 14, chacune des aubes 18 forme un ensemble 1, associant une pale 20, une plateforme 22, et un pied d'aube 24. Les plateformes d'aubes 22 sont ainsi réalisées de manière intégrée avec les pales 20. Naturellement, l'invention peut être mise en oeuvre dans d'autres types de roues, dans lesquelles les pales et la ou les plateforme(s) constituent des pièces distinctes.

Les pieds 24 permettent la fixation des aubes 18 sur le disque rotor 16.

Les plateformes 22 associées au sein de la roue à aubes 14 définissent une surface de plateforme 30 qui délimite du côté radialement intérieur les veines inter-aubes permettant le passage de gaz entre les aubes. Cette surface de plateforme est approximativement une surface de révolution - ou du moins peut être approximée par une surface de révolution -.

Les aubes 18 sont agencées de telle sorte que, lorsqu'elles sont assemblées ensemble de manière à former la roue 14, les plateformes des aubes définissent entièrement la surface de plateforme 30 formée entre les pales 20. Aussi, aucune pièce supplémentaire ne fait partie de ou ne forme la surface de plateforme 30. Pour permettre l'assemblage des aubes 18, le bord 32 des surfaces de plateforme sur un premier côté suivant la direction circonférentielle de la roue à aubes est de forme complémentaire à la forme du bord 34 des surfaces de plateforme situé du côté opposé suivant la direction circonférentielle C.

Chaque pale 20 comporte un bord d'attaque 26 et un bord de fuite 28, et s'étend radialement suivant une direction radiale B propre à chaque pale.

Sur la figure 2 est indiqué un plan de coupe V, qui constitue un plan de section sensiblement parallèle à la surface de plateforme 30, et est situé au voisinage du pied de la pale 20.

La figure 5 représente une coupe d'une pale 120 d'aube de turbomachine, dans un plan perpendiculaire à l'axe longitudinal de la pale.

Dans cette coupe apparaît la fibre neutre 122 de la pale, pour le plan considéré. La fibre neutre est l'ensemble des points de la pale équidistants des deux faces latérales (intrados et extrados) de la pale. Par exemple le point M représenté est à la même distance d de l'intrados et de l'extrados. L'angle squelette α au point M est l'angle entre la tangente 124 à la fibre neutre au point M, et l'axe A de la roue. L'angle squelette α0 ou angle squelette amont, est l'angle squelette au bord d'attaque de la pale 120.

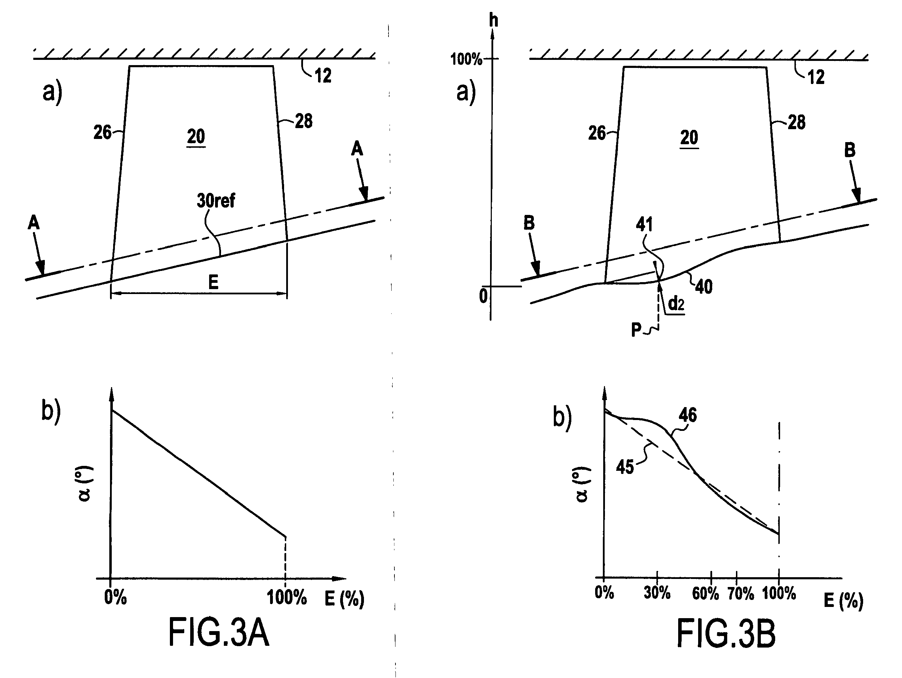

Les figures 3A et 3B présentent respectivement un ensemble 1 (associant une plateforme 22 et une pale 20) respectivement dans un mode de réalisation connu, et dans un mode de réalisation selon l'invention.
Figure 3A :
La surface de plateforme 30 représentée sur la figure 3A(a) n'a fait l'objet d'aucun aménagement spécifique au niveau (axialement, c'est-à-dire suivant l'axe A) de la pale 20. Cette surface de plateforme est donc une surface de plateforme de référence 30_{ref} qui est sensiblement conique.

Sur la figure 3Ab est tracée la courbe des variations de l'angle squelette de la pale de la figure 3A(a), dans le plan A-A (plan indiqué en trait mixte sur la figure 3Aa)), en fonction de la position axiale suivant l'axe de la roue 14. La position axiale est indiquée en pourcentage, en fonction de la position par rapport à l'étendue axiale E de la pale 20. L'étendue axiale E est la distance séparant suivant l'axe A le bord d'attaque 26 du bord de fuite 28, au pied des pales 20 (fig 3A.a)). La pale 20 de l'ensemble de la figure 3A est une pale type dont les courbes de squelette et de squelette linéarisé, représentées sur la figure 3Ab, sont confondues.
Figure 3B :
La figure 3B représente un mode de réalisation de l'invention. Dans celui-ci, la surface de plateforme 30 a été aménagée au niveau de la pale 20.

Les aménagements réalisés se définissent radialement de manière relative, par rapport à la surface de plateforme de référence 30_{ref}. Cette surface 30_{ref} se définit comme la surface sensiblement conique approchant la surface de plateforme - 30, cette surface de référence 30_{ref} étant déterminée sans prendre en compte ni la dépression circonférentielle ni le cas échéant d'autres aménagements localisés (circonférentiels ou non) en saillie ou en creux de la surface de plateforme effectués axialement au niveau des pales 20.

Les aménagements de la surface de plateforme 30 et des pales 20 se définissent d'autre part axialement par rapport à l'étendue axiale E des pales 20.

La surface de plateforme 30 est aménagée (fig.3B.a)) avec une dépression circonférentielle 40. Par dépression, on désigne une partie de la surface de plateforme se trouvant radialement à l'intérieur de la surface de plateforme de référence 30_{ref} et correspondant à une réouverture locale de la veine.

La dépression circonférentielle 40 s'étend axialement entre le bord d'attaque 26 et le bord de fuite 28 des pales 20. La section axiale 41 (qui se trouve dans un plan P perpendiculaire à l'axe A de la roue 14) la plus creuse de cette dépression 40 est située axialement dans la moitié amont de la pale 20. Dans la phrase précédente, la section 'la plus creuse' désigne la section de la dépression 40 dont la distance d2 par rapport à la surface de plateforme de référence 30ref est la plus grande (voir fig.3Ba). Dans le mode de réalisation présenté (Fig.3Bb), la section la plus creuse 41 est située axialement entre 15 et 40% de l'étendue axiale E de la pale à partir de son bord d'attaque, et plus précisément à environ 30% de cette étendue E.

La dépression circonférentielle 40 indiquée précédemment améliore le rendement de la roue à aubes 14. Inversement, elle perturbe l'écoulement du fluide au voisinage de la surface de plateforme, par rapport à l'écoulement que permet la surface de plateforme théorique 30_{ref}.

Selon l'invention, pour compenser ces perturbations, la forme des pales 20 est modifiée de la manière présentée par les figures 3B(b) et 4. Cette modification affecte (de manière générale) principalement 40% de la hauteur des pales 20, du côté radialement intérieur. Cette modification apparaît notamment dans un plan de coupe de la pale (plan V, figure 2) qui est sensiblement parallèle à la surface de plateforme, et situé au voisinage de la plateforme.

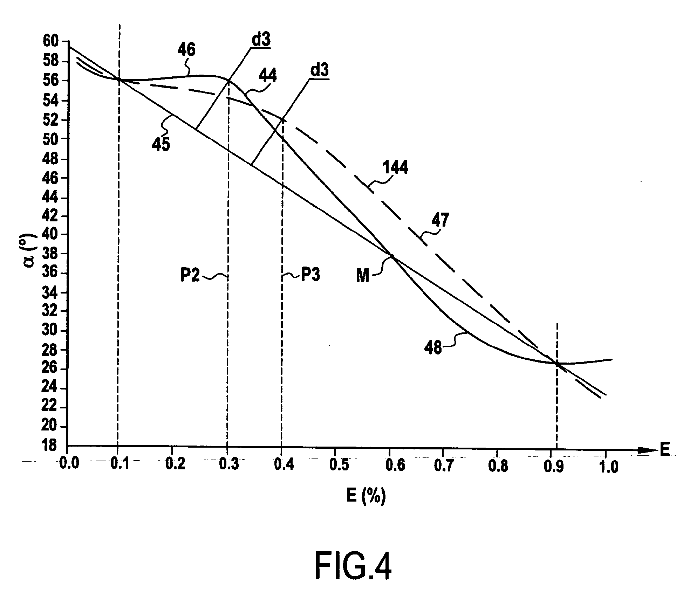

Cette modification est présentée sur la figure 4 sur laquelle apparaissent :
- en trait fort, la courbe de squelette 46, représentant les variations de l'angle squelette α de la pale 20 du premier mode de réalisation de l'invention (figure 3B) ;
- en pointillé, la courbe de squelette 47, représentant les variations de l'angle squelette α d'une pale dans un second mode de réalisation de l'invention ; et
- en trait fin, la courbe de squelette linéarisé 45 de la pale 20, qui représente les variations de l'angle squelette linéarisé et est la même pour les deux modes de réalisation.

Dans ces différentes courbes, les variations de l'angle squelette α sont représentées en fonction de la position axiale sur la pale, cette position axiale étant indiquée sous forme de pourcentage par rapport à l'étendue axiale E de la pale 20.

Dans les deux modes de réalisation, la forme de la surface de plateforme est la même et est illustrée par la figure 3B.

La modification apportée selon l'invention à la pale 20 consiste dans le fait que la courbe d'angle squelette présente une partie rehaussée se trouvant au-dessus de la courbe 45 de squelette linéarisé. (Par partie rehaussée, on entend une partie de courbe se trouvant au-dessus de la courbe d'angle squelette linéarisé : en d'autres termes, dans la partie rehaussée, l'angle squelette est supérieur en valeur absolue, et est plus fermé, par rapport à l'angle squelette linéarisé). Cette partie rehaussée est notée 44 et 144 respectivement pour le premier et le deuxième mode de réalisation.

Une caractéristique notable de la partie rehaussée est la position de la section d3, qui est la section pour laquelle l'écart entre la courbe de squelette (46 ou 47) et la courbe de squelette linéarisé 45 est maximum, et plus particulièrement la position de cette section d3 par rapport à la section la plus creuse 41 de la dépression circonférentielle 40. Dans le premier mode de réalisation (courbe squelette 46), le plan (perpendiculaire à l'axe de la roue à aubes) de la section d3 est confondu avec le plan P (fig.3Bb) de la section 41 la plus creuse de la dépression circonférentielle.

De manière générale, le plan de la section d3 est de préférence situé axialement de part et d'autre de la section la plus creuse 41, à savoir entre la position 0,5 x N% de la section la plus creuse 41, et 1,5 x N%, la valeur N étant un pourcentage exprimé par rapport à l'étendue axiale E de la pale 20. Dans les modes de réalisation présentés, comme indiqué précédemment, le plan P (de la section la plus creuse 41 de la dépression circonférentielle 40) se trouve à environ 30% de E. Suivant le critère précédent, la section la plus creuse doit donc se trouver entre 0,5 x 30% et 1,5 x 30%, c'est-à-dire entre 15% et 45% de E. C'est bien le cas pour le premier mode de réalisation, puisque la section d3 se trouve à 30% de E pour la courbe 46, et pour le deuxième mode de réalisation, puisque la section d3 de la courbe 47 se trouve à 40% de E.

Par ailleurs, la courbe de squelette peut présenter ou non une partie abaissée en aval de la partie rehaussée. Dans le premier mode de réalisation, la partie rehaussée 44 s'étend sur une plage allant jusqu'à environ 60% de l'étendue axiale E. En aval de la partie rehaussée 44, la courbe 46 présente une partie abaissée 48. Cette dernière s'étend axialement environ de 60% à 90% de l'étendue axiale E. Par suite, la courbe squelette 46 et la courbe de squelette linéarisé 45 se croisent en un point, M, situé entre 50% et 75% de l'étendue axiale E de la pale. Sur la figure 4 on constate que le point M est situé à 60% de E.

Dans le deuxième mode de réalisation contrairement au premier, la courbe de squelette 47 ne comporte pas de partie abaissée en aval de la partie rehaussée. Au contraire, la courbe de squelette 47 reste au-dessus de la courbe de squelette linéarisé 45, avec une partie rehaussée 144 s'étendant sur presque la totalité de l'étendue axiale de la pale (entre 10% et 90%).

## Revendications

1. Ensemble (1) comportant une pale (20) pour roue à aubes de turbomachine et une plateforme (22) sur laquelle la pale est apte à être montée ;
une pluralité desdites pales étant aptes à être fixées sur ladite plateforme ou sur une pluralité desdites plateformes assemblées ensemble, de manière à former une roue à aubes (14) présentant un axe de roue (A) et définissant suivant celui-ci des directions amont et aval, roue dans laquelle les pales sont disposées radialement ;
dans ladite roue, la plateforme (22) ou les plateformes assemblées présentant entre les pales une surface (30) dite surface de plateforme, délimitant radialement du côté intérieur des veines de passage de gaz formées entre les pales ;
ladite surface de plateforme présentant une dépression circonférentielle (40), s'étendant axialement sensiblement entre un bord d'attaque et un bord de fuite de la pale, une section la plus creuse (41) de ladite dépression se situant axialement dans la moitié amont de la pale,
l'ensemble **se caractérisant en ce que**,
une courbe de squelette (46,47) étant la courbe représentant les variations d'un angle squelette (α) de la pale dans un plan de section parallèle à la surface de plateforme, en fonction de la position suivant l'axe de la roue,
une courbe de squelette linéarisé (45) étant la courbe représentative des variations d'un angle en fonction de la position suivant l'axe de la roue, qui relie en ligne droite les points représentant l'angle squelette respectivement à 10% et à 90% de l'étendue axiale de la pale à partir du bord d'attaque,
dans un voisinage de la plateforme, la courbe de squelette présente une partie réhaussée (44) se trouvant au dessus de la courbe (45) de squelette linéarisé.

2. Ensemble selon la revendication 1, dans lequel un plan (P2) dans lequel un écart (d3) entre la courbe de squelette (46) et la courbe de squelette linéarisé (45) est maximum est sensiblement confondu avec le plan (P) de ladite section (41) la plus creuse.

3. Ensemble selon la revendication 1, dans lequel un plan (P2, P3) dans lequel un écart entre la courbe de squelette (47) et la courbe de squelette linéarisé (45) est maximum est situé axialement entre la position 0,5 x N% de ladite section (41) la plus creuse et 1,5 x N%, la valeur N étant un pourcentage exprimé par rapport à l'étendue axiale de la pale à partir de son bord d'attaque.

4. Ensemble selon l'une quelconque des revendications 1 à 3, dans lequel ladite section (41) la plus creuse est située axialement entre 15 et 40% de l'étendue axiale de la pale, à partir de son bord d'attaque.

5. Ensemble selon l'une quelconque des revendications 1 à 4, dans lequel la courbe squelette présente une partie abaissée (48) se trouvant sous la courbe d'angle squelette linéarisé et située axialement en aval de ladite partie rehaussée (44).

6. Ensemble selon la revendication 5, dans lequel la courbe squelette et la courbe de squelette linéarisé se croisent en un point (M) situé entre 50% et 75% de l'étendue axiale de la pale à partir de son bord d'attaque.

7. Aube (18) pour turbomachine comportant un ensemble selon l'une quelconque des revendications 1 à 6, comprenant une plateforme formée intégralement avec au moins une pale.

8. Roue à aubes (14) pour turbomachine formée avec des aubes selon la revendication 7.

9. Roue à aubes (14) pour turbomachine formée avec au moins un ensemble selon l'une quelconque des revendications 1 à 6.

10. Turbomachine (100), comprenant au moins une roue à aubes selon la revendication 8 ou 9.

## Patentansprüche

1. Anordnung (1), umfassend ein Blatt (20) für ein Schaufelrad einer Turbomaschine und eine Plattform (22), an der das Blatt anbringbar ist,
wobei eine Vielzahl der Blätter geeignet ist, an der Plattform oder an einer Vielzahl der zusammengefügten Plattformen befestigt zu werden, um ein Schaufelrad (14) zu bilden, das eine Radachse (A) aufweist und entlang dieser eine stromaufwärtige und eine stromabwärtige Richtung definiert, Rad, bei dem die Blätter radial angeordnet sind,
wobei bei dem Rad die Plattform (22) oder die zusammengefügten Plattformen zwischen den Blättern eine Oberfläche (30), sogenannte Plattformoberfläche, aufweist/aufweisen, die auf der Innenseite Gasdurchgangskanäle, welche zwischen den Blättern gebildet sind, radial begrenzt,
wobei die Plattformoberfläche eine Umfangsmulde (40) aufweist, die sich im Wesentlichen zwischen einer Eintrittskante und einer Austrittskante des Blattes axial erstreckt, wobei ein tiefster Abschnitt (41) der Mulde axial in der stromaufwärtigen Hälfte des Blattes gelegen ist,
wobei die Anordnung **dadurch gekennzeichnet ist, dass**
eine Skelettlinienkurve (46, 47) die Kurve ist, welche die Änderungen eines Skelettlinienwinkels (α) des Blattes in einer Querschnittsebene parallel zu der Plattformoberfläche, in Abhängigkeit von der Position entlang der Achse des Rades darstellt,
wobei eine linearisierte Skelettlinienkurve (45) die für die Änderungen eines Winkels in Abhängigkeit von der Position entlang der Achse des Rades repräsentative Kurve ist, welche die Punkte, die den Skelettlinienwinkel bei 10 % bzw. bei 90 % der axialen Ausdehnung des Blattes von der Eintrittskante aus darstellen, in gerader Linie verbindet,
in einer Nähe der Plattform die Skelettlinienkurve einen erhöhten Teil (44) aufweist, der sich oberhalb der linearisierten Skelettlinienkurve (45) befindet.

2. Anordnung nach Anspruch 1, bei der eine Ebene (P2), in der ein Abstand (d3) zwischen der Skelettlinienkurve (46) und der linearisierten Skelettlinienkurve (45) maximal ist, mit der Ebene (P) des tiefsten Abschnitts (41) im Wesentlichen verschmolzen ist.

3. Anordnung nach Anspruch 1, bei der eine Ebene (P2, P3), in der ein Abstand zwischen der Skelettlinienkurve (47) und der linearisierten Skelettlinienkurve (45) maximal ist, axial zwischen der Position 0,5 x N % des tiefsten Abschnitts (41) und 1,5 x N % gelegen ist, wobei der Wert N ein in Bezug auf die axiale Ausdehnung des Blattes von seiner Eintrittskante aus ausgedrückter Prozentsatz ist.

4. Anordnung nach einem der Ansprüche 1 bis 3, bei der der tiefste Abschnitt (41) axial zwischen 15 und 40 % der axialen Ausdehnung des Blattes von seiner Eintrittskante aus gelegen ist.

5. Anordnung nach einem der Ansprüche 1 bis 4, bei der die Skelettlinienkurve einen abgesenkten Teil (48) aufweist, der sich unter der linearisierten Skelettlinienwinkelkurve befindet und axial stromabwärts des erhöhten Teils (44) gelegen ist.

6. Anordnung nach Anspruch 5, bei der die Skelettlinienkurve und die linearisierte Skelettlinienkurve sich in einem Punkt (M) kreuzen, der zwischen 50 % und 75 % der axialen Ausdehnung des Blattes von seiner Eintrittskante aus gelegen ist.

7. Schaufel (18) für eine Turbomaschine, mit einer Anordnung nach einem der Ansprüche 1 bis 6, umfassend eine Plattform, die mit wenigstens einem Blatt integral ausgebildet ist.

8. Schaufelrad (14) für eine Turbomaschine, das mit Schaufeln nach Anspruch 7 ausgebildet ist.

9. Schaufelrad (14) für eine Turbomaschine, das mit wenigstens einer Anordnung nach einem der Ansprüche 1 bis 6 ausgebildet ist.

10. Turbomaschine (100), die wenigstens ein Schaufelrad nach Anspruch 8 oder 9 umfasst.

## Claims

1. An assembly (1) comprising an airfoil (20) for a turbine engine rotor wheel and a platform (22) on which the airfoil is suitable for being mounted:
· a plurality of said airfoils being suitable for being fastened to said platform or to a plurality of said platforms assembled together so as to form a rotor wheel (14) having a wheel axis (A) and defining upstream and downstream directions along that axis, the airfoils being arranged radially in the wheel;
· in said wheel, the platform (22) or the assembled-together platforms present a surface (30) between the airfoils that is referred to as a platform surface and that radially defines the inside of gas-passing passages formed between the airfoils; and
· said platform surface presenting a circumferential depression (40) extending axially substantially between a leading edge and a trailing edge of an airfoil, a deepest section (41) of said depression being situated axially in the upstream half of the airfoil;
said assembly being **characterized in that**:
where a "skeleton curve" (46, 47) is the curve representing the variations of a skeleton angle (α) of the airfoil in a section plane substantially parallel to the platform surface, as a function of position along the axis of the wheel;
where a "linearized skeleton curve" (45) is the curve representing variations of an angle as a function of position along the axis of the wheel, which curve is a straight line connecting together points representing the skeleton angle respectively at 10% and at 90% of the axial extent of the airfoil from the leading edge,
in a vicinity of the platform, the skeleton curve presents a raised portion (44) lying above the linearized skeleton curve (45).

2. An assembly according to claim 1, wherein a plane (P2) in which an offset (d₃) between the skeleton curve (46) and the linearized skeleton curve (45) is at a maximum substantially coincides with the plane (P) of said deepest section (41).

3. An assembly according to claim 1, wherein a plane (P2, P3) in which an offset between the skeleton curve (47) and the linearized skeleton curve (45) is at a maximum is situated axially between the position at 0.5 x N% of said deepest section (41) and 1.5 x N%, the value N being a percentage expressed relative to the axial extent of the airfoil from its leading edge.

4. An assembly according to any one of claims 1 to 3, wherein said deepest section (41) is situated axially in the range 15% to 40% of the axial extent of the airfoil from its leading edge.

5. An assembly according to any one of claims 1 to 4, wherein the skeleton curve presents a lowered portion (48) lying under the linearized skeleton curve and situated axially downstream from said raised portion (44).

6. An assembly according to claim 5, wherein the skeleton curve and the linearized skeleton curve intersect at a point (M) situated in the range 50% to 75% of the axial extent of the airfoil from its leading edge.

7. A blade (18) for a turbine engine and including an assembly according to any one of claims 1 to 6, the blade comprising a platform formed integrally with at least one airfoil.

8. A turbine engine rotor wheel (14) formed with blades according to claim 7.

9. A turbine engine rotor wheel (14) formed with at least one assembly according to any one of claims 1 to 6.

10. A turbine engine (100) including at least one rotor wheel according to claim 8 or claim 9.
